(19) Europäisches Patentamt
European Patent Office
Office européen des brevets

(11) EP 3 357 093 B1

(12) **EUROPÄISCHE PATENTSCHRIFT**

(45) Veröffentlichungstag und Bekanntmachung des Hinweises auf die Patenterteilung:
**27.10.2021 Patentblatt 2021/43**

(21) Anmeldenummer: **16770520.1**

(22) Anmeldetag: **26.09.2016**

(51) Int Cl.:
*H01L 33/00* (2010.01)    *H01L 33/38* (2010.01)
*H01L 33/44* (2010.01)    *H01L 31/105* (2006.01)
*H01L 31/18* (2006.01)    *H01L 33/62* (2010.01)
*H01L 31/0224* (2006.01)

(86) Internationale Anmeldenummer:
**PCT/EP2016/072854**

(87) Internationale Veröffentlichungsnummer:
**WO 2017/055215 (06.04.2017 Gazette 2017/14)**

(54) **OPTOELEKTRONISCHER HALBLEITERCHIP UND DESSEN HERSTELLUNGSVERFAHREN**

OPTOELECTRONIC SEMICONDUCTOR CHIP AND METHOD OF MANUFACTURING THE SAME

PUCE OPTOÉLECTRONIQUE À SEMI-CONDUCTEURS ET SON PROCÉDÉ DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.09.2015 DE 102015116495**

(43) Veröffentlichungstag der Anmeldung:
**08.08.2018 Patentblatt 2018/32**

(73) Patentinhaber: **OSRAM Opto Semiconductors GmbH**
**93055 Regensburg (DE)**

(72) Erfinder:
• **HARTMANN, Rainer**
**93047 Regensburg (DE)**
• **MANDL, Martin**
**93138 Lappersdorf (DE)**
• **KATZ, Simeon**
**93083 Obertraubling (DE)**
• **RÜCKERL, Andreas**
**94357 Konzell (DE)**

(74) Vertreter: **Epping - Hermann - Fischer**
**Patentanwaltsgesellschaft mbH**
**Schloßschmidstraße 5**
**80639 München (DE)**

(56) Entgegenhaltungen:
WO-A1-2014/090605          DE-A1-102007 022 947
DE-A1-102010 013 494       DE-A1-102010 048 159
DE-A1-102011 115 659       US-A1- 2010 140 636
US-A1- 2013 285 067

**Beschreibung**

Die vorliegende Erfindung betrifft einen optoelektronischen Halbleiterchip und ein Verfahren zum Herstellen eines optoelektronischen Halbleiterchips.

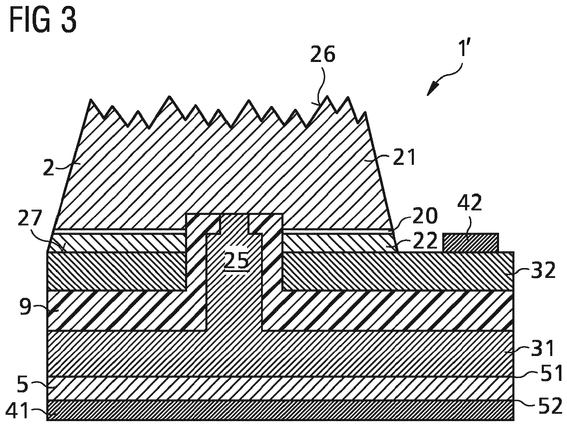

Dünnfilm-Leuchtdiodenchips bestehen charakteristischerweise aus einem Halbleiterkörper zur Erzeugung und/oder zum Empfangen von Strahlung, einem Träger (zum Beispiel Si, Ge), das nicht dem Wachstumssubstrat für die epitaktische Herstellung der lichtemittierenden Schichtfolge entspricht, sowie einer ersten und einer zweiten elektrischen Anschlussschicht, die mittels einer Trennschicht elektrisch voneinander isoliert sind. Figur 3 zeigt in schematischer Schnittansicht einen Dünnfilm-Leuchtdiodenchip aus dem Stand der Technik in der Ausbildung eines Oberflächenemitters. Der Leuchtdiodenchip (1') weist einen Halbleiterkörper (2) auf, der eine Halbleiterschichtenfolge umfasst. Die Halbleiterschichtenfolge hat insbesondere einen aktiven Bereich (20), der zur Erzeugung und/oder zum Empfangen von Strahlung ausgebildet ist. Typischerweise ist der aktive Bereich (20) zwischen einer ersten Halbleiterschicht (21) und einer zweiten Halbleiterschicht (22) mit unterschiedlichem Leitungstyp angeordnet. Beispielsweise ist die erste, der Vorderseite zugewandten Halbleiterschicht (21) n-leitend und die zweite, der Vorderseite abgewandten Halbleiterschicht (22) p-leitend.

Der Halbleiterkörper (2) ist auf der Vorderseite (51) eines elektrisch leitenden Trägers (5) angeordnet. Zwischen Halbleiterkörper (2) und Träger (5) befinden sich typischerweise eine erste (31) und eine zweite (32) elektrische Anschlussschicht sowie zur elektrischen Trennung dieser eine isolierende Trennschicht (9). Die Kontaktierung der ersten Halbleiterschicht (21) erfolgt über Ausnehmungen (25) im Halbleiterkörper (2) und über die erste Anschlussschicht (31) zu einem ersten Kontakt (41), der sich auf der Rückseite des Trägers (5) befindet. Über die zweite Anschlussschicht (32) ist die zweite Halbleiterschicht (22) mit einem zweiten Kontakt (42) auf der Vorderseite des Halbleiterchips elektrisch leitend verbunden. Der vorgestellte Leuchtdiodenchip (1') verfügt demnach sowohl über einen vorderseitigen Kontakt (42) als auch einen rückseitigen Kontakt (41).

Für diverse Anwendungen ist ein Dünnfilm-Leuchtdiodenchip von Vorteil, dessen Kontakte sich ausschließlich auf der Vorderseite befinden. Für einen solchen im Folgenden rückseitenisolierter Chip genannter Leuchtdiodenchip ist eine elektrische Trennung von Chiprückseite und Chipvorderseite notwendig. Es darf zwischen der Chiprückseite und den elektrischen Anschlussschichten (31, 32) keine elektrische Verbindung bestehen. Eine elektrische Trennung von Vorderseite und Rückseite eines Dünnfilm-Leuchtdiodenchips lässt sich beispielsweise durch die Verwendung eines keramischen Trägers (beispielsweise aus AlN, SiN), eines Glasträgers oder eines hochohmigen, z.B. undotierten bzw. niederdotierten Siliziumträgers bzw. Germaniumträgers realisieren. Solche Lösungen sind in der Praxis oft teuer und lassen sich nur schwer in den bestehenden Herstellungsprozess von standardmäßigen Dünnfilm-Leuchtdiodenchips integrieren.

Optoelektronische Bauelemente sind beispielsweise in den Druckschriften DE 102011115659 A1, US 2013/0285067 A1, DE 102010048159 A1, DE 102010013494 A1, DE 102007022947 A1,

US 2010/0140636 A1 und WO 2014/090605 A1 beschrieben.

Eine Aufgabe ist es, einen optoelektronischen Halbleiterchip und ein Verfahren zur Herstellung eines optoelektronischen Halbleiterchips anzugeben, welche eine verbesserte Rückseiten-Isolierung erlauben.

Diese Aufgabe wird unter anderem durch die Gegenstände der unabhängigen Ansprüche 1 und 13 gelöst. Weitere Ausgestaltungen sind Gegenstand der abhängigen Ansprüche.

Gemäß zumindest einer Ausführungsform weist ein optoelektronischer Halbleiterchip einen Träger auf, auf dem eine Halbleiterschichtenfolge angeordnet ist. Ferner weist der Halbleiterchip eine Chipvorderseite und eine Chiprückseite auf. Die Halbleiterschichtenfolge ist bevorzugt epitaktisch gewachsen. Bevorzugt handelt es sich bei dem Halbleiterchip um einen Dünnfilm-Halbleiterchip. Der Dünnfilm-Halbleiterchip ist bevorzugt frei von einem Aufwachssubstrat der Halbleiterschichtenfolge oder das Aufwachssubstrat ist derart gedünnt, dass es alleine nicht mehr mechanisch stabilisierend für die Halbleiterschichtenfolge ist. Zur mechanischen Stabilisation umfasst der Dünnfilm-Halbleiterchip in der Regel den Träger. Bevorzugt ist der Träger elektrisch leitend ausgebildet. Die Halbleiterschichtenfolge kann fügemittelfrei mittels Bonden an dem Träger befestigt sein. Weiterhin ist es auch möglich, dass die Halbleiterschichtenfolge mit einer Fügeschicht, beispielsweise einer Lotschicht oder eine Klebstoffschicht, an dem Träger befestigt ist.

Die Halbleiterschichtenfolge umfasst einen aktiven Bereich, der zwischen einer ersten Halbleiterschicht und einer zweiten Halbleiterschicht angeordnet ist. Der aktive Bereich der Halbleiterschichtenfolge ist zur Erzeugung oder zum Empfangen von elektromagnetischer Strahlung vorgesehen. Der aktive Bereich ist beispielsweise zum Empfangen oder zum Erzeugen von Strahlung im ultravioletten, sichtbaren oder infraroten Spektrum ausgebildet. Ferner ist der aktive Bereich beispielsweise zwischen der ersten Halbleiterschicht und der zweiten Halbleiterschicht angeordnet. Zweckmäßigerweise sind die erste Halbleiterschicht und die zweite Halbleiterschicht aus einem Halbleitermaterial mit verschiedenem Leitungstyp. Beispielsweise ist die erste Halbleiterschicht n-leitend und die zweite Halbleiterschicht p-leitend oder umgekehrt. In der Regel sind die erste Halbleiterschicht und die zweite Halbleiterschicht elektrisch leitend ausgebildet und zählen zu den elektrisch leitenden Bereichen des Halbleiterchips. Die Halbleiterschichtenfolge kann einen Halbleiterkörper ausbilden oder Teil eines Halbleiterkörpers sein. Der Halbleiterkörper muss hierbei nicht zwingend aus einem Halbleitermaterial bestehen. Vielmehr kann der Halbleiterkörper neben einer Halbleiterschichtenfolge auch metallische oder oxidische Schichten aufweisen.

Die erste Halbleiterschicht ist elektrisch leitend mit einem ersten Kontakt verbunden. Der erste Kontakt ist auf der Chipvorderseite, insbesondere neben dem aktiven Bereich, ausgebildet. Die zweite Halbleiterschicht ist elektrisch leitend mit einem zweiten Kontakt verbunden. Dabei ist der zweite Kontakt ebenfalls auf der Chipvorderseite, insbesondere neben dem aktiven Bereich, ausgebildet. Beispielsweise sind der erste und zweite Kontakt auf oder in der Nähe von zwei gegenüberliegenden Außenseiten des Halbleiterchips und seitlich vom Halbleiterkörper an der Chipvorderseite angeordnet.

Ferner ist eine zusätzliche elektrisch isolierende Trennschicht vorgesehen. Diese befindet sich beispielsweise zwischen der dem Träger näheren elektrischen Anschlussschicht, also etwa der ersten Anschlussschicht, und dem Träger und bedeckt beide vollständig. Alternativ kann die isolierende Trennschicht ganzflächig auf der Rückseite des Trägers angeordnet sein. Die isolierende Trennschicht umfasst eine oder mehrere atomare oder molekulare Monolagen.

Denkbar ist auch ein Träger in der Ausbildung eines Drei-Schichtensystems, bei dem die isolierende Trennschicht in der Art einer Zwischenschicht (englisch *"interlayer"*) beidseitig vom Trägermaterial (z.B. Si oder Ge) umschlossen ist. Bei einem Dünnfilm-Leuchtdiodenchip ohne externen Träger befindet sich die Trennschicht bevorzugt auf der Chiprückseite auf der der Rückseite näheren Anschlussschicht.

Bevorzugt sind zwischen Träger und Halbleiterkörper eine erste und eine zweite elektrische Anschlussschicht angeordnet. Die erste und die zweite Anschlussschicht sind mittels einer Isolationsschicht elektrisch voneinander isoliert.

Gemäß zumindest einer Ausführungsform ist die isolierende Trennschicht auf einer Vorderseite des Trägers, auf einer Rückseite des Trägers oder innerhalb des Trägers angeordnet ist. Beispielsweise ist die isolierende Trennschicht zwischen derjenigen Anschlussschicht und dem Träger angeordnet, die dem Träger am nächsten liegt.

Die elektrisch isolierende Trennschicht weist zumindest eine erste Trennschicht auf. Diese erste Trennschicht weist wenigstens eine Atomlagenschicht oder zumindest eine Moleküllagenschicht auf. Beispielsweise ist die erste Trennschicht als eine geschlossene Schicht ohne Ausnehmungen oder Poren ausgebildet. Eine solche Schicht kann erfindungsgemäß durch Atomlagenabscheidung oder Moleküllagenabscheidung durch zwei oder mehr zyklisch durchgeführte selbstbegrenzende Oberflächenreaktionen auf einer Oberfläche des Halbleiterkörpers oder des Trägers erzielt werden.

Gemäß zumindest einer Ausführungsform weist die Atomlagenschicht und/oder die Moleküllagenschicht eine oder mehrere Lagen auf. Bei einer Atomlagenabscheidung oder einer Moleküllagenschichtabscheidung kann durch eine selbstbegrenzende Reaktion die Trennschicht pro Verfahrenszyklus um einen bestimmbaren Wert anwachsen. Die Trennschicht wächst so proportional zur Zahl der Reaktionszyklen, was eine exakte Steuerung der Schichtdicke ermöglicht.

Gemäß zumindest einer Ausführungsform weist die erste Trennschicht zumindest eine oder mehrere isolierende Oxid- oder Nitridverbindungen auf, beispielsweise $Al_xO_y$, $SiO_2$, $Ta_xO_y$, $TaN$, $TiO$, $SiN$, $AlN$, $TiN$, $ZrO_2$, $HfO_2$, $HfSiO_4$, $ZrSiO_4$, $HfSiON$.

Gemäß zumindest einer Ausführungsform weist die elektrisch isolierende Trennschicht eine Schichtenfolge aus elektrisch isolierenden Materialien auf. Insbesondere können die elektrisch isolierenden Materialien unterschiedlich sein.

Die Schichtenfolge umfasst die erste Trennschicht und zumindest eine zweite Trennschicht. Die zweite Trennschicht weist dabei eine oder mehrere Abscheidungslagen auf. Beispielsweise kann die zweite Trennschicht mit alternativen Verfahren mit hohen Abscheideraten, wie der Gasphasenabscheidung oder des Sputterverfahrens, aufgebracht werden. Die erste und zweite Trennschicht können aufeinander abgestimmt sein und eine verbesserte elektrische Isolierung erreichen. Die erste Trennschicht wird dabei unmittelbar in zeitlicher Folge auf die zweite Trennschicht aufgebracht.

Gemäß zumindest einer Ausführungsform weist die Schichtenfolge eine dritte Trennschicht auf. Die dritte Trennschicht weist dabei bevorzugt eine oder mehrere Schichtlagen auf, die mittels Gasphasenabscheidung oder Sputterverfahren abgeschieden wurden. Die Abscheidung der ersten Trennschicht folgt der Abscheidung der zweiten und/oder der dritten Trennschicht.

In einer weiteren Ausführungsform ist die erste Trennschicht von der zweiten und dritten Trennschicht zumindest teilweise umschlossen. Die erste Trennschicht ist damit eine Zwischenschicht, die auf ihren Oberflächen durch die zweite und dritte Trennschicht zumindest teilweise umschlossen ist.

Gemäß zumindest einer Ausführungsform weisen die zweite und/oder die dritte Trennschicht zumindest eine oder mehrere isolierende Oxid- oder Nitridverbindungen beispielsweise $Al_xO_y$, $SiO_2$, $Ta_xO_y$, $TaN$, $TiO$, $SiN$, $AlN$, $TiN$, $ZrO_2$, $HfO_2$, $HfSiO_4$, $ZrSiO_4$, $HfSiON$.

Gemäß zumindest einer Ausführungsform weist der Träger ein elektrisch leitendes Material oder halbleitendes Material auf. So sind Silizium oder Germanium als Material für den Träger geeignet. Ferner kann der Träger ein Moldmaterial, ein keramisches Material und/oder ein hochohmiges Material aufweisen. Beispielsweise hat die Wahl des Trägermaterials Auswirkungen auf dessen thermischen Ausdehnungskoeffizienten und kann je nach Anwendungsfeld angepasst werden. Ein keramisches Material bzw. ein hochohmiges Material kann beispielsweise für eine zusätzliche elektrische Isolierung vorgesehen sein.

Gemäß zumindest einer Ausführungsform ist die erste Halbleiterschicht auf der dem Träger abgewandten Seite des aktiven Bereichs angeordnet. Die erste Halbleiterschicht ist über eine erste Anschlussschicht mit dem ersten Kontakt elektrisch leitend verbunden.

Gemäß zumindest einer Ausführungsform weist der Halbleiterkörper zumindest eine Ausnehmung auf, die sich durch die zweite Halbleiterschicht und den aktiven Bereich hindurch in die erste Halbleiterschicht erstreckt. Dabei ist die erste Anschlussschicht zumindest teilweise in der Ausnehmung angeordnet und mit der ersten Halbleiterschicht elektrisch leitend verbunden.

Gemäß zumindest einer Ausführungsform ist die zweite Halbleiterschicht über eine zweite Anschlussschicht mit dem zweiten Kontakt elektrisch leitend verbunden. Dabei ist die zweite Anschlussschicht auf der dem Träger zugewandten Seite des aktiven Bereichs angeordnet.

Gemäß einer Ausführungsform des Halbleiterchips ist die elektrisch isolierende Trennschicht vollflächig auf einer Hauptfläche des Trägers ausgebildet ist, besonders bevorzugt in direktem Kontakt mit dem Träger. Weiterhin besteht die elektrisch isolierende Trennschicht bei dieser Ausführungsform aus einer ersten Trennschicht, die mittels Atomlagenabscheidung oder Moleküllagenabscheidung gebildet ist, sowie einer zweiten Trennschicht und einer dritten Trennschicht, die mittels Gasphasenabscheidung gebildet sind, wobei die erste Trennschicht zwischen der zweiten Trennschicht und der dritten Trennschicht angeordnet ist und wobei die erste Trennschicht mit der zweiten Trennschicht und der dritten Trennschicht in direktem Kontakt steht, bevorzugt jeweils vollflächig. Mit anderen Worten sind die erste Trennschicht, die zweite Trennschicht und die dritte Trennschicht jeweils bevorzugt unmittelbar aufeinander aufgebracht, wobei die erste Trennschicht zwischen der zweiten und der dritten Trennschicht angeordnet ist.

Eine derartige isolierende Trennschicht weist den Vorteil auf eine sehr gute Durchschlagsfestigkeit bei gleichzeitig geringer Prozessierungsdauer aufzuweisen.

Die folgenden Element des Halbleiterchips zählen in der Regel zu den elektrisch leitenden Bereichen des Halbleiterchips: der aktive, strahlungserzeugende Bereich, die Anschlussschichten, die elektrischen Kontakte und die Halbleiterschichten. Bevorzugt isoliert die elektrisch isolierende Trennschicht die Chiprückseite und/oder den Träger von den elektrisch leitenden Bereichen. Besonders bevorzugt isoliert die elektrisch isolierende Trennschicht die Chiprückseite und/oder den Träger von dem aktiven Bereich. Die Chiprückseite kann beispielsweise durch eine Hauptfläche des Trägers gebildet sein. Der Träger und/oder die Chiprückseite können elektrisch leitend ausgebildet sein.

Ein Verfahren zum Herstellen eines optoelektronischen Halbleiterchips mit einer Chipvorderseite und einer Chiprückseite umfasst die in den nächsten beiden Absätzen beschriebenen Schritte.

Zunächst wird eine Halbleiterschichtenfolge bereitgestellt, die einen aktiven Bereich aufweist, der zwischen einer ersten Halbleiterschicht und einer zweiten Halbleiterschicht angeordnet ist. Es wird ein erster Kontakt auf der Chipvorderseite, insbesondere neben dem aktiven Bereich, ausgebildet. Ferner wird eine elektrisch leitende Verbindung zwischen der ersten Halbleiterschicht und dem ersten Kontakt hergestellt. Zudem wird ein zweiter Kontakt auf der Chipvorderseite, insbesondere neben dem aktiven Bereich, ausgebildet. Zudem wird eine elektrisch leitende Verbindung zwischen der zweiten Halbleiterschicht und dem zweiten Kontakt hergestellt.

Eine elektrisch isolierende Trennschicht wird auf einer dem Träger abgewandten Rückseite des Halbleiterkörpers, auf der Vorderseite des Trägers oder im Träger ausgebildet. Schließlich wird ein Verbund aus Halbleiterschichtenfolge und Träger gebildet und zum Halbleiterchip zusammengefügt.

Gemäß zumindest einer Ausführungsform umfasst das Verfahren zum Herstellen eines optoelektronischen Halbleiterchips die folgenden Schritte:

1. Es wird auf einem Aufwachssubstrat eine Halbleiterschichtenfolge bereitgestellt, die den aktiven Bereich aufweist, der zwischen der ersten Halbleiterschicht und der zweiten Halbleiterschicht angeordnet ist.
2. Es wird eine zweite elektrische Anschlussschicht auf der zweiten Halbleiterschicht aufgebracht.
3. Es wird ein Durchbruch im aktiven Bereich ausgebildet.
4. Anschließend wird die Trennschicht an der Rückseite der Halbleiterschichtenfolge aufgebracht.
5. Es wird eine erste elektrische Anschlussschicht an der Rückseite der Halbleiterschichtenfolge aufgebracht, wobei ein Teilbereich der ersten elektrischen Anschlussschicht in dem Durchbruch ausgebildet wird.
6. Die elektrisch isolierende Trennschicht wird ganzflächig auf die erste Anschlussschicht aufgebracht.
7. Es wird ein Verbund aus Halbleiterschichtenfolge, Träger und Anschlussschichten gebildet und zum Halbleiterchip zusammengefügt.
8. Das Aufwachssubstrat wird gedünnt oder vollständig entfernt.
9. Die Halbleiterschichtenfolge wird stellenweise entfernt, und der erste und zweite Kontakt werden aufgebracht.

Alternativ zu Schritt 6) wird die isolierende Trennschicht ganzflächig auf einer Vorderseite oder einer Rückseite des Trägers aufgebracht. Letzteres ist auch nach der Verbundbildung möglich. Alternativ enthält der Träger die beidseitig teilweise umschlossene Trennschicht.

Die elektrisch isolierende Trennschicht wird mittels einer Atomlagenabscheidung oder mittels einer Moleküllagenabscheidung auf die dem Träger zugewandte Seite des Halbleiterkörpers oder auf den Träger aufgebracht.

Die elektrisch isolierende Trennschicht wird als eine Kombination aus einer ersten Trennschicht auf Basis einer Atomlagenabscheidung oder Moleküllagenabscheidung mit wenigstens einer weiteren Trennschicht auf Basis einer Gasphasenabscheidung bzw. auf Basis eines Sputterverfahrens ausgeführt. Die Schicht auf Basis der Atomlagenabscheidung / Moleküllagenabscheidung schließt dabei unmittelbar an mindestens einer Gasphasenabscheidung wie einer CVD-basierenden (englisch *"chemical vapour deposition"*) oder einer aufgesputterten Schicht an, wobei erstere der zweiten zeitlich nachfolgend abgeschieden wird.

Atomlagenabscheidung (englisch *"atomic layer deposition"*, ALD) oder Moleküllagenabscheidung (englisch *"molecular layer deposition"*) sind erfindungsgemäße Verfahren zur Herstellung der elektrisch isolierenden Trennschicht als Atomlagenschicht oder Moleküllagenschicht. Die Verfahren führen zur Abscheidung von dünnen Schichten oder Lagen durch zwei oder mehr zyklisch durchgeführte selbstbegrenzende Oberflächenreaktionen. Die Schichten haben in der Regel eine polykristalline oder amorphe Struktur. Im Rahmen des vorgelegten Prinzips soll unter Atomlagenabscheidung oder Moleküllagenabscheidung jedoch nicht eine herkömmliche Gasphasenabscheidung bzw. das CVD-Verfahren (englisch *"chemical vapour deposition"*) verstanden werden.

Bei einem CVD-Verfahren (*"chemical vapour deposition"*, chemische Gasphasenabscheidung) wird ebenfalls die zu beschichtende Oberfläche in einem Volumen zur Verfügung gestellt. In dem Volumen wird weiterhin zumindest ein Ausgangsmaterial zur Verfügung gestellt, aus dem durch eine chemische Reaktion an der zu beschichtenden Oberfläche eine feste CVD-Schicht abgeschieden wird. In der Regel befindet sich in dem Volumen zumindest ein zweites Ausgangsmaterial, mit dem das erste Ausgangsmaterial unter Bildung der festen CVD-Schicht an der Oberfläche chemisch reagiert.

Im Unterschied zu CVD-Verfahren werden bei einer Atomlagenabscheidung oder einer Moleküllagenabscheidung die Ausgangsstoffe zyklisch und nacheinander zur Reaktion gebracht. Die Teilreaktionen können voneinander getrennt und auf die Oberfläche begrenzt werden. Die Teilreaktionen sind dabei selbstbegrenzend, d.h. ein Ausgangsstoff einer Teilreaktion reagiert nicht mit sich selbst oder Liganden von sich selbst, was das Schichtwachstum einer Teilreaktion pro Zyklus auf maximal eine Monolage begrenzt.

Gemäß zumindest einer Ausführungsform wird die elektrisch isolierende Trennschicht mittels zumindest eines der unter den folgenden Bezeichnungen bekannten Atomlagenbeschichtungs und/oder Moleküllagenbeschichtungs-Verfahren aufgebracht:

- atomic layer deposition (Atomlagenabscheidung),
- atomic layer epitaxy (Atomlagenepitaxie),
- atomic layer evaporation,
- atomic layer growth,

- molecular layer deposition (Moleküllagenabscheidung),
- molecular layer epitaxy (Moleküllagenepitaxie).

Bei einem ALD-Verfahren (*"atomic layer deposition"*, Atomlagenabscheidung) wird die zu beschichtende Oberfläche in einem Volumen zur Verfügung gestellt. Dem Volumen wird zumindest ein erstes gasförmiges Ausgangsmaterial zur zugeführt, das auf der zu beschichteten Oberfläche adsorbiert. Nach einer bevorzugt vollständigen oder nahezu vollständigen Bedeckung der zu beschichtenden Oberfläche mit dem ersten Ausgangsmaterial wird der Teil des ersten Ausgangsmaterial, der noch gasförmig bzw. nicht auf der Oberfläche adsorbiert vorliegt, in der Regel wieder aus dem Volumen entfernt und dem Volumen ein zweites Ausgangsmaterial zugeführt. Das zweite Ausgangsmaterial ist dafür vorgesehen, mit der an der Oberfläche adsorbierten, ersten Ausgangsmaterial unter Bildung einer festen ALD-Schicht chemisch zu reagieren. Weiterhin ist die feste ALD-Schicht in der Regel zumindest teilweise an die zu beschichtende Oberfläche kovalent gekoppelt.

Das ALD-Verfahren zeichnet sich somit durch mindestens eine chemische Reaktion an der zu beschichtenden Oberfläche zur Bildung der ALD-Schicht aus. In der Regel findet die chemische Reaktion bei einer bestimmten Reaktionstemperatur statt. Besonders bevorzugt weist die zu beschichtende Oberfläche die Reaktionstemperatur auf, bei der chemische Reaktion zur Bildung der festen ALD-Schicht stattfindet. Bei dem ALD-Verfahren können auch mehr als zwei Ausgangsmaterialien zum Einsatz kommen.

Gegenüber anderen Abscheideverfahren aus der Gasphase, wie etwa einem CVD-Verfahren (*"chemical vapour deposition"*, CVD) zeichnet sich ein ALD-Verfahren insbesondere dadurch aus, dass die jeweiligen Ausgangsmaterialien für die chemische Reaktion zur Bildung der abzuscheidenden Schicht voneinander getrennt in das Volumen eingelassen werden und nicht adsorbierte oder chemisch umgesetzte Anteile der Ausgangsmaterialien aus dem Volumen wieder entfernt werden, bevor dem Volumen ein weiteres Ausgangsmaterial zugeführt wird. Das ALD-Verfahren weist den Vorteil auf, eine besonders gute Kontrolle der Schichtdicke der abzuscheidenden Schicht zu ermöglichen. Weiterhin kann mit einem ALD-Verfahren eine strukturierte Oberfläche mit einem hohen Aspektverhältnis sehr gut abgeformt werden.

Die mit einem ALD-Verfahren abgeschiedene ALD-Schicht zeichnet sich insbesondere durch eine sehr homogene Schichtdicke und durch eine sehr homogene Schichtstruktur auf. Insbesondere weist die ALD-Schicht wenig Defekte, wie beispielsweise Pinholes, und eine hohe Dichte auf.

Besonders bevorzugt wird vorliegend ein ALD-Verfahren zur Abscheidung der elektrisch isolierenden Trennschicht verwendet. Gemäß einer Ausführungsform des Verfahrens wird die elektrisch isolierende Trennschicht vollflächig auf einer Hauptfläche des Trägers ausgebildet, bevorzugt in direktem Kontakt mit dem Träger. Weiterhin wird die elektrisch isolierende Trennschicht aus einer ersten Trennschicht, einer zweiten Trennschicht und einer dritten Trennschicht gebildet, wobei die erste Trennschicht zwischen der zweiten Trennschicht und der dritten Trennschicht angeordnet ist und die erste Trennschicht mit der zweiten Trennschicht und der dritten Trennschicht in direktem Kontakt steht. Die erste Trennschicht wird hierbei bevorzugt mit Atomlagenabscheidung oder Moleküllagenabscheidung und besonders bevorzugt mit einem ALD-Verfahren gebildet, und die zweite und dritte Trennschicht mittels Gasphasenabscheidung.

Beim vorgestellten optoelektronischen Halbleiterchip wird die elektrische Trennung von Vorder- und Rückseite durch das Einbringen einer zusätzlichen elektrisch nichtleitenden Schicht in den Chip erreicht. Durch die elektrisch isolierende Trennschicht ist es möglich, eine einfache elektrische Isolation von Vorder- und Rückseite eines Dünnfilm-Leuchtdiodenchips zu erreichen. Auf spezielle, elektrisch isolierende Trägermaterialien kann verzichtet werden, was die vorgeschlagene Ausgestaltung und Methode besonders kostengünstig macht. Ferner lässt sich die vorgeschlagene Methode in bekannte Standardprozesse zur Herstellung von optoelektronischen Halbleiterchips integrieren. Insbesondere zeigen sich im Gegensatz zur Verwendung anderer Trägermaterialien, wie etwa keramikbasierter Substrate, nur marginale bis keine Auswirkungen auf die Prozessierbarkeit der Halbleiterbauelemente.

Insbesondere ist die vorgeschlagene Methode kompatibel zu bestehenden Trennprozessen, mit denen von einem Wafer eine Vielzahl von optoelektronischen Halbleiterchips vereinzelt wird. Dies ist bei keramischen Trägern aufgrund des Auftretens von "Chipping" nicht möglich. Letztere müssen in einem sogenannten "Scribe & Break" Verfahren aufwendig getrennt werden. Eine im Vergleich zu keramischen Trägern verbesserte Kompatibilität besteht auch hinsichtlich bestehender Verbundungstechnologien. Bei keramischen Trägern treten vielmehr aufgrund von CTE-Fehlanpassungen (Wärmeausdehnungskoeffizient, englisch *"coefficient of thermal expansion",* CTE) hohe Bruchraten bei Träger und/oder Saphir auf. Letztlich ist das vorgeschlagene Verfahren auch kompatibel mit der bestehenden Rückseitenmetallisierung. Haftungsthemen sind anders als bei keramischen Trägern nicht zu erwarten. Ein weiterer Vorteil der vorgeschlagenen Methode im Vergleich zu einer keramikbasierten Rückseitenisolation ist die gute thermische Anbindung des so erzeugten Chips an sein Gehäuse, da der überwiegende Teil des LED-Chips aus Materialien mit hoher thermischer Leitfähigkeit bestehen kann, wie beispielsweise GaN und Silizium.

Das vorgestellte Verfahren eignet sich nicht nur für unterschiedliche Leuchtdiodenchips. Entsprechend lässt sich das Verfahren auch für einen Dünnfilmchip vorteilhaft einsetzen, bei dem sich die Kontaktschicht für die erste Halbleiterschicht auf dem Halbleiterkörper an der Chipvorderseite befindet. Auch sind Dünnfilm-Halbleiterchips denkbar, die keine Ausnehmungen aufweisen und solche Dünnfilm-Halbleiterchips bei den der Anschluss für die erste Halbleiterschichtenfolge auf dem Halbleiterkörper angeordnet ist. Ferner sind trägerlose Dünnfilm-Halbleiterchips als Variante möglich. Beispielsweise weist deren Träger ein Moldmaterial auf.

Trennschichten auf Basis einer Gasphasenabscheidung, etwa aus $SiO_2$ und/oder $SiN_x$, werden wegen der Temperaturempfindlichkeit des optoelektronischen Halbleiterchips bei relativ geringen Temperaturen hergestellt. Dies führt unter anderem zur Ausbildung von Poren und Pinholes im Dielektrikum, die sich in einer deutlichen Herabsetzung der Durchbruchspannung bemerkbar machen. Zusätzlich bilden sich bei einem CVD-Verfahren an Stufen (in der Topographie) des Bauteils Risse in den Schichten aus. Die Anforderungen an die Rückseitenisolation des optoelektronischen Halbleiterchips können so regelmäßig nicht erreicht werden.

Durch die erste Trennschicht alleine oder in Schichtenfolge mit wenigstens einer zweiten Trennschicht auf Basis der Gasphasenabscheidung oder eines Sputterverfahrens können Poren oder Pinholes einer bereits abgeschiedenen Schicht geschlossen und die elektrische Isolation weiter verbessert werden. Eine Atomlagen bzw. Moleküllagenschicht stellt eine typischerweise geschlossene Schicht mit sehr guten Überformungseigenschaften dar. Somit kann die erste Trennschicht (z.B. ALD) den negativen Auswirkungen von Pinholes und Rissen auf die Durchbruchfestigkeit entgegenwirken. Pinholes an einer Oberfläche der Gasphasenschichten werden ausgefüllt, was ebenso für die an Stufen vermehrt auftretenden Rissen in den Schichten gilt.

Die Durchbruchfestigkeit einer idealen dielektrischen Schicht folgt der Beziehung:

$$U_{br} = E_{crit} \cdot d,$$

wobei $U_{br}$ die Durchbruchspannung, $E_{crit}$ die für das Schichtversagen kritische Feldstärke und d die Schichtdicke wiedergeben. Eine hohe Durchbruchspannung kann also durch einen hohen Wert von $E_{crit}$ bzw. einer großen Schichtdicke d erreicht werden. Die Schichtdicke d lässt sich von Kostenthemen und Verspannungsthemen abgesehen im Wesentlichen frei einstellen. $E_{crit}$ ist dagegen ein Schichtparameter, der vom Material und dem Abscheideverfahren bestimmt wird. Schichten eines bestimmten Materials auf Basis von Atomlagenabscheidung bzw. Moleküllagenabscheidung haben naturgemäß einen höheren Wert von $E_{crit}$ als Schichten desselben Materials auf Basis von CVD oder Sputtern. ALD-Schichten werden aber aufgrund der geringen Abscheideraten der betreffenden Beschichtungsmethoden typischerweise nur mit geringen Schichtdicken (etwa <200 nm) realisiert. Demgegenüber ermöglichen Gasphasenabscheidung bzw. das Sputterverfahren aufgrund ihrer hohen Abscheideraten innerhalb genügend kurzer Prozesszeit relativ große Schichtdicken von einigen 100 nm. Dem stehen aufgrund der infolge der Poren und Risse schlechteren Schichtqualität (insbesondere bei den geringen Beschichtungstemperaturen) jedoch relativ kleine Werte von $E_{crit}$ gegenüber. Mit Hilfe einer anschließenden Atomlagenabscheidung bzw. Moleküllagenabscheidung können diese Poren und Risse geschlossen werden, was zu einer Erhöhung von $E_{crit}$ und somit von $U_{br}$ führt. Die Gesamtdicke d der Schichtfolge ändert sich aufgrund der relativ geringen Aufwachsraten der Atomlagenabscheidung / Moleküllagenabscheidung dabei nur unbedeutend. Mit Hilfe einer geeigneten Kombination von Schichten auf der Basis von Gasphasenabscheidung bzw. Sputterverfahren und Atomlagenabscheidung / Moleküllagenabscheidung können sowohl die Schichtdicke d als auch die kritische Feldstärke $E_{crit}$ hinsichtlich einer hohen Durchbruchspannung optimiert werden.

Insgesamt lassen sich mithilfe der ersten Trennschicht elektrische Durchbrüche bei niederen angelegten Spannungen, die typischerweise der Anwesenheit von Pinholes zugeschrieben werden, eliminieren bzw. verringern. Die Durchbruchfestigkeit nähert sich so dem intrinsischen Wert einer Pinhole-freien CVD-Bulk-Schicht an. Zusammenfassend ermöglicht das Einbringen der ersten Trennschicht also eine zuverlässigere Isolation von Vorder- und Rückseite mittels eines zusätzlichen Dielektrikums im Schichtaufbau des optoelektronischen Halbleiterchips.

Weitere Vorteile und vorteilhafte Ausgestaltungen sowie Weiterbildungen ergeben sich aus den folgenden, in Zusammenhang mit Figuren dargestellten Ausführungsbeispielen.

Es zeigen:

die Figur 1    ein Ausführungsbeispiel für einen optoelektronischen Halbleiterchip in schematischer Schnittansicht,

die Figur 2    Messcharakteristiken von optoelektronischen Halbleiterchips mit verschiedenen Trennschichten, und

die Figur 3    ein Beispiel eines optoelektronischen Halbleiterchips in schematischer Schnittansicht aus dem Stand der Technik.

Gleiche, gleichartige oder gleichwirkende Elemente sind in den Figuren mit gleichen Bezugszeichen versehen. Die Figuren und die Größenverhältnisse der in den Figuren dargestellten Elemente untereinander sind nicht als maßstäblich zu betrachten. Vielmehr können einzelne Elemente und insbesondere Schichtdicken zur besseren Darstellbarkeit und/oder zum besseren Verständnis übertrieben groß dargestellt sein.

Die Beschreibung erfolgt nachfolgend exemplarisch anhand eines zur Erzeugung von Strahlung vorgesehenen Halbleiterchips, beispielsweise eines Leuchtdioden-Halbleiterchips, etwa einer LED. Davon abweichend kann der Halbleiterchip auch als ein Strahlungsempfänger ausgebildet sein, bei dem ein aktiver Bereich zur Erzeugung eines elektrischen Signals in Abhängigkeit von der auf den aktiven Bereich auftreffenden Strahlungsleistung vorgesehen ist.

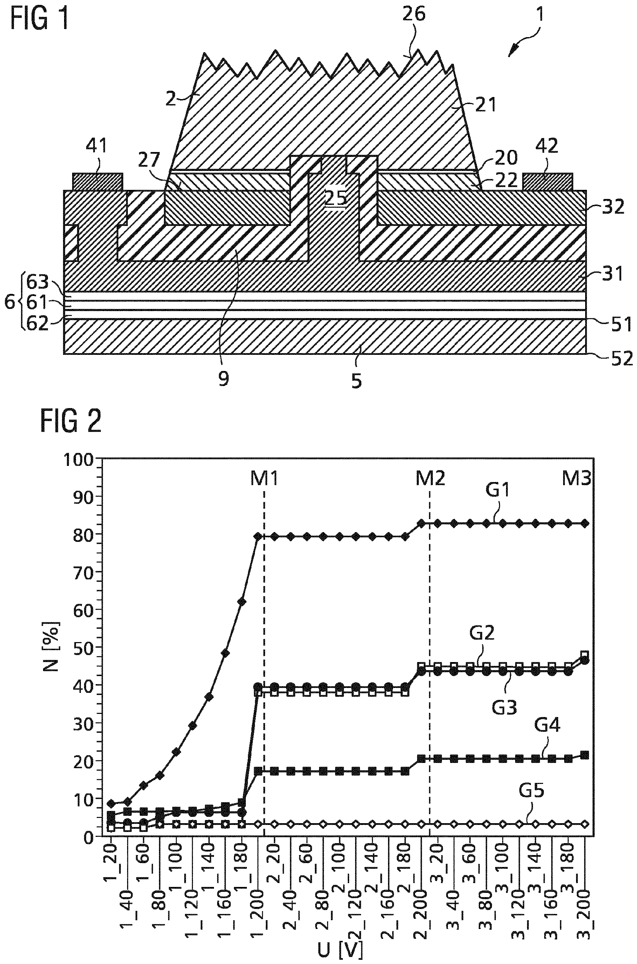

Figur 1 zeigt ein Ausführungsbeispiel für einen optoelektronischen Halbleiterchip in schematischer Schnittansicht.

Der optoelektronische Halbleiterchip 1 umfasst einen Halbleiterkörper 2. Der Halbleiterkörper 2 weist eine Halbleiterschichtenfolge mit einem aktiven Bereich 20 auf. Der aktive Bereich 20 ist zur Erzeugung von Strahlung im ultravioletten, sichtbaren oder infraroten Spektralbereich vorgesehen. In vertikaler Richtung, also senkrecht zu einer Haupterstreckungsebene der Halbleiterschichtenfolge des Halbleiterkörpers, erstreckt sich der Halbleiterkörper 2 zwischen einer Strahlungsdurchtrittsfläche 26 und einer Hauptfläche 27. Der aktive Bereich 20 ist zwischen einer ersten Halbleiterschicht 21 eines ersten Leitungstyps und einer zweiten Halbleiterschicht 22 eines vom ersten Leitungstyp verschiedenen zweiten Leitungstyps angeordnet. Beispielsweise ist die erste Halbleiterschicht n-leitend und die zweite Halbleiterschicht p-leitend oder umgekehrt. Der Halbleiterkörper, insbesondere der aktive Bereich, enthält vorzugsweise ein III-V- oder ein II-VI-Verbindungs-Halbleitermaterial.

Der optoelektronische Halbleiterchip 1 ist beispielsweise als ein Dünnfilm-Halbleiterchip ausgebildet, bei dem ein Aufwachssubstrat für die Halbleiterschichtenfolge des Halbleiterkörpers 2 nach deren epitaktischen Abscheidung entfernt ist. Ein solcher Halbleiterchip stellt in guter Näherung einen Lambertschen Oberflächenstrahler dar. Davon abweichend kann das Aufwachssubstrat aber auch vollständig im Halbleiterchip verbleiben oder nur bereichsweise entfernt oder ausgedünnt sein.

III-V-Verbindungs-Halbleitermaterialien sind zur Strahlungserzeugung im ultravioletten ($Al_xIn_yGa_{1-x-y}N$) über den sichtbaren ($Al_xIn_yGa_{1-x-y}N$, insbesondere für blaue bis grüne Strahlung, oder $Al_xIn_yGa_{1-x-y}P$, insbesondere für gelbe bis rote Strahlung) bis in den infraroten ($Al_xIn_yGa_{1-x-y}As$) Spektralbereich besonders geeignet. Hierbei gilt jeweils $0 \leq x \leq 1$, $0 \leq y \leq 1$ und $x + y \leq 1$, insbesondere mit $x \neq 1$, $y \neq 1$, $x \neq 0$ und/oder $y \neq 0$. Mit III-V-Verbindungs-Halbleitermaterialien, insbesondere aus den genannten Materialsystemen, können weiterhin bei der Strahlungserzeugung hohe interne Quanteneffizienzen erzielt werden.

Der Halbleiterkörper 2 weist eine Mehrzahl von Ausnehmungen 25 auf, die sich von der Hauptfläche 27 durch die zweite Halbleiterschicht 22 und den aktiven Bereich 20 hindurch in die erste Halbleiterschicht 21 hinein erstrecken und dort enden. Aus Gründen der besseren Darstellbarkeit sind in der Zeichnung nur zwei Ausnehmungen 25 dargestellt. Die Ausnehmungen 25 sind jeweils elektrisch leitend mit einer ersten Anschlussschicht 31 verbunden, die sich zwischen Halbleiterkörper 2 und Träger 5 erstreckt. Mittels der Anschlussschicht 31 sind die Ausnehmungen 25 untereinander elektrisch leitend verbunden.

Über die Mehrzahl von Ausnehmungen 25 können Ladungsträger in lateraler Richtung gleichmäßig in die erste Halbleiterschicht 21 injiziert werden. Insbesondere abhängig von der Querleitfähigkeit der ersten Halbleiterschicht 21 kann die Anzahl der Ausnehmungen 25 in weiten Grenzen variiert werden. Im Extremfall kann bereits eine einzelne Ausnehmung 25 für die elektrische Kontaktierung der ersten Halbleiterschicht 21 ausreichend sein.

Der Halbleiterchip 1 umfasst einen Träger 5, der sich in vertikaler Richtung zwischen einer Vorderseite 51 und einer Rückseite 52 erstreckt. In dieser Ausführungsform weist der Träger 5 beispielsweise ein dotiertes Halbleitermaterial, etwa Silizium oder Germanium auf. Zwischen Träger 5 und Halbleiterkörper 2 sind die erste und die zweite elektrische Anschlussschicht 31, 32 angeordnet. Der Halbleiterkörper 2 ist zusammen mit den Anschlussschichten 31, 32 mittels einer Verbindungsschicht (nicht gezeigt), beispielsweise mittels einer elektrisch leitfähigen Klebeschicht oder mittels einer Lotschicht, mit dem Träger 5 mechanisch stabil verbunden.

Zudem bedeckt die erste Anschlussschicht 31 den Träger 5 im Bereich der Ausnehmungen 25 vollflächig und erstreckt sich horizontal entlang der Vorderseite 51 des Trägers 5. Im Bereich einer Ausnehmung 25 ist die erste Anschlussschicht 31 in lateraler Richtung durch eine Isolationsschicht 9 der Ausnehmung begrenzt, die sich in vertikaler Richtung durch die Ausnehmung entlang der Halbleiterschichtenfolge erstreckt. Die erste Halbleiterschicht 21 ist über die erste Anschlussschicht 31 mit einem ersten Kontakt 41 elektrisch leitend verbunden. Letzterer befindet sich an der Vorderseite des Halbleiterchips seitlich vom Halbleiterkörper 2.

Der optoelektronische Halbleiterchip 1 umfasst weiterhin eine zweite Anschlussschicht 32, die elektrisch leitend mit der zweiten Halbleiterschicht 22 verbunden ist. Die Anschlussschicht 32 erstreckt sich zumindest teilweise in horizontaler Richtung entlang der Hauptfläche 27 des Halbleiterkörpers 2. Die Anschlussschicht 32 erstreckt sich lateral so weit, dass an einem Ende ein zweiter Kontakt 42 ausgebildet ist. Die erste Anschlussschicht 31 und die zweite Anschlussschicht 32 können in Aufsicht auf den Halbleiterchip 1 zumindest bereichsweise überlappen.

Der erste und zweite Kontakt 41, 42 können als eine zusätzlich zur ersten oder zweiten Anschlussschicht 31, 32 vorgesehene Schicht ausgebildet sein, wie es in Figur 1 dargestellt ist. Alternativ kann auch ein für eine externe elektrische Kontaktierung frei zugänglicher Bereich der ersten oder zweiten Anschlussschicht 31, 32 selbst die Kontakte 41, 42 bilden.

Zwischen der ersten Anschlussschicht 31 und der zweiten Anschlussschicht 32 und zudem teilweise entlang des Trägers 5 ist eine Isolationsschicht 9 ausgebildet. Die Isolationsschicht 9 bedeckt zudem Seitenflächen der Ausnehmungen 25 und isoliert so die erste Anschlussschicht 31 von der zweiten Halbleiterschicht 22 und vom aktiven Bereich 20. Mit anderen Worten sind der erste Kontakt 41 und der zweite Kontakt 42 lediglich über eine Diode elektrisch leitend miteinander verbunden. Im Betrieb des optoelektronischen Halbleiterchips 1 kann daher zwischen dem ersten Kontakt 41 und dem zweiten Kontakt 42 eine externe elektrische Spannung angelegt werden, so dass Ladungsträger in den aktiven Bereich 20 injiziert werden und dort unter Emission von Strahlung rekombinieren.

Zwischen dem Halbleiterkörper 2 und dem Träger 5 ist eine elektrisch isolierende Trennschicht 6 vorgesehen. Die elektrisch isolierende Trennschicht 6 erstreckt sich in horizontaler Richtung parallel zur Hauptfläche 27 des Halbleiterkörpers 2 bzw. entlang der Vorderseite 51 des Trägers 5. In diesem Ausführungsbeispiel umfasst die elektrisch isolierende Trennschicht 6 eine Schichtenfolge aus einer ersten Trennschicht 61, einer zweiten Trennschicht 62 und einer dritten Trennschicht 63.

Die erste Trennschicht 61 ist eine geschlossene Schicht, die mit einem Atomlagenabscheidungsverfahren (hier: ALD) ausgebildet wird. Alternativ kann die erste Trennschicht 61 auch mit einem Moleküllagenabscheidungsverfahren (hier: MLD) ausgebildet sein. Die erste Trennschicht 61 umfasst mindestens eine Monolage aus einem elektrisch isolierenden Material, beispielsweise $Al_2O_3$, $SiO_2$ oder $Ta_2O_5$ oder einer Kombination aus diesen Stoffen. Die erste Trennschicht 61 hat beispielsweise eine Dicke von ca. 40 nm, umfasst also mehrere Monolagen. Die erste Trennschicht 61 kann je nach gewünschtem Isolierungsgrad und Anwendungsfeld andere Dicken aufweisen, die mehrere 100 nm ausmachen können. Die Dicke der ersten Trennschicht 61 wird beispielsweise aus Kostenabwägungen auf eine kleinere Dicke begrenzt, weil das Atomlagenabscheidungsverfahren Monolagen nur nacheinander auftragen kann und somit zeitlich aufwändig ist.

Die erste Trennschicht 61 stellt ein Dielektrikum dar, welches nach Art einer Zwischenschicht (englisch *"interlayer"*) von der zweiten und dritten Trennschicht 62, 63 umfasst ist. Sowohl die zweite als auch die dritte Trennschicht 62, 63 stellen Schichten dar, die mittels eines Gasphasenabscheidungsverfahrens bzw. eines Sputterverfahrens aufgetragen sind. Als Materialien kommen hier ebenfalls elektrisch isolierende Materialien in Frage, beispielsweise $SiO_2$, $SiN_x$ oder Si-ON.

Infolge der Abscheidung aus der Gasphase bei niedrigen Temperaturen weisen die zweite und dritte Trennschicht 62, 63 Pinholes und Poren auf, die sich in einer deutlichen Herabsetzung der Durchbruchspannung bemerkbar machen würden. Zusätzlich bilden sich an den Stufen in der Topographie Risse in den beiden Trennschichten. Die erste Trennschicht 61 ist eine in hohem Grade geschlossene Schicht mit sehr guten Überformungseigenschaften, die schon als Einzelschicht eine hohe zuverlässige elektrische Isolierung bereitstellt.

Durch das unmittelbare Aufbringen der ersten Trennschicht 61 auf die CVDbasierte Schicht wird den Auswirkungen der Pinholes und Risse auf die Durchbruchfestigkeit entgegengewirkt, und es werden diese gewissermaßen verschlossen oder gefüllt. Auf diese Weise können elektrische Durchbrüche bei niederen angelegten Spannungen, beispielsweise im Bereich von 100 V bis 200 V, eliminiert bzw. verringert werden. Das Aufbringen der ersten Trennschicht auf eine CVD-basierende bzw. gesputterte Schicht bzw. das Einbringen der ersten Trennschicht 61 als Zwischenschicht erlaubt somit eine noch zuverlässigere Isolation von Vorder- und Rückseite des optoelektronischen Halbleiterchips als es mit einer herkömmlichen CVD-basierten Schicht bzw. Schichtenfolge möglich wäre.

In weiteren Ausführungsformen (nicht gezeigt) sind Dünnfilm-Halbleiterchips denkbar, die keine Ausnehmungen 25 aufweisen und solche Dünnfilm-Halbleiterchips bei den der Anschluss 32 für die erste Halbleiterschichtenfolge auf dem Halbleiterkörper 2 angeordnet ist. Ferner sind trägerlose Dünnfilm-Halbleiterchips als Variante möglich. Beispielsweise weist deren Träger ein Moldmaterial auf.

Figur 2 zeigt die Messcharakteristiken von optoelektronischen Halbleiterchips mit unterschiedlichen Isolationsschichten 9.

Dargestellt sind Messkurven, mit denen die verbesserte elektrische Isolation mittels des vorgestellten Verfahrens verdeutlicht wird. Gezeigt sind unterschiedliche Kurven, die die Ergebnisse von verschiedenen Isolationsvorkehrungen gegenüberstellen. Hierbei wurden jeweils verschiedene Spannungen zwischen Chipvorderseite und Chiprückseite angelegt und die Anzahl der Chips mit Durchbrüchen ermittelt. Die Kurven G1 bis G4 entstammen aus Halbleiterchips mit Isolationsschichten, die vollständig mit der Gasphasenabscheidung aufgebracht wurden. Die Schichten haben jeweils die gleiche Gesamtdicke, sie unterscheiden sich lediglich in der Anordnung und/oder den Dicken der Einzelschichten aus $SiO_2$ und $SiN_x$. Die Kurve G5 schließlich zeigt die Messdaten an einer Schichtenfolge aus der ersten, zweiten und dritten Trennschicht 61, 62, 63 wie sie in Zusammenhang mit Figur 1 diskutiert wurde. Aufgetragen ist in der X-Achse eine an den jeweiligen Halbleiterchip angelegte Spannung U[V] in einem ersten, zweiten und dritten Messzyklus. Die Spannung wurde dabei von null auf einen Wert $U_{max}$ gesteigert. Für jeden Wert U wurden dann die Halbleiterchips aussortiert, die infolge der Spannung ein Versagen der Isolation zeigten. Die Zahl dieser aussortierten Halbleiterchips ist auf der y-Achse in Prozent angegeben.

Die Grafik zeigt einen überraschenden Effekt, der mit der Schichtenfolge des vorgeschlagenen Prinzips erzielbar ist. Die Kurve G1 zeigt, dass eine Schichtenfolge lediglich aus Schichten aus einer Gasphasenabscheidung schon im ersten Messzyklus zu einem erheblichen Ausfall N[%] von nahe 80 % führt. Durch geeignete Variation der CVD-basierten Einzelschichten bei gleicher Gesamtdicke kann die Ausfallrate zwar deutlich reduziert werden, sie bleibt jedoch hoch und kann zu zusätzlichen Kosten und Aufwand in der Produktion und Testphase von Halbleiterchips führen. Ferner fällt auf, dass die Ausfallrate N[%] mit der angelegten Spannung U erwartungsgemäß ansteigt. Die vorgeschlagene Schichtenfolge hingegen zeigt einen deutlich anderen Verlauf. Die Ausfallrate ist gemäß Messkurve G5 nicht nur deutlich reduziert, sondern sie ist innerhalb des Testbereichs auch unabhängig von der angelegten Spannung. Die vernachlässigbaren Ausfälle bei minimalem Wert von U im ersten Messzyklus werden auf anderweitige Probleme des betreffenden Halbleiterchips, etwa Prozessierungsfehler, zurückgeführt.

Die vorliegende Anmeldung beansprucht die Priorität der deutschen Anmeldung DE 102015116495.7.

Die Erfindung ist nicht durch die oben beschriebenen Ausführungsbeispiele beschränkt, sondern durch die beigefügten Patentansprüche definiert.

Bezugszeichenliste

| | |
|---|---|
| 1, 1' | optoelektronischer Halbleiterchip |
| 2 | Halbleiterkörper |
| 5 | Träger |
| 6 | Trennungsschicht |
| 9 | Isolationsschicht |
| 20 | aktiver Bereich |
| 21 | Halbleiterschicht |
| 22 | Halbleiterschicht |
| 25 | Ausnehmung |
| 26 | Strahlungsdurchtrittsfläche |
| 27 | Hauptfläche |
| 31 | erste Anschlussschicht |
| 32 | zweite Anschlussschicht |
| 41 | Kontakt |
| 42 | Kontakt |
| 51 | Vorderseite des Trägers |
| 52 | Rückseite des Trägers |
| 61 | erste Trennschicht |
| 62 | zweite Trennschicht |
| 63 | dritte Trennschicht |
| G1 | Messkurve |
| G2 | Messkurve |
| G3 | Messkurve |
| G4 | Messkurve |
| G5 | Messkurve |
| M1 | erster Messzyklus |
| M2 | zweiter Messzyklus |
| M3 | dritter Messzyklus |
| N[%] | Ausfallrate |
| U[V] | Spannung |

**Patentansprüche**

1.  Optoelektronischer Halbleiterchip (1), der einen Träger (5) und einen auf dem Träger (5) angeordneten Halbleiterkörper (2) mit einer Halbleiterschichtenfolge, sowie eine Chipvorderseite und eine Chiprückseite aufweist, wobei

    - die Halbleiterschichtenfolge einen aktiven Bereich (20) umfasst, der zwischen einer ersten Halbleiterschicht (21) und einer zweiten Halbleiterschicht (22) angeordnet ist und zur Erzeugung oder zum Empfangen von elektromagnetischer Strahlung vorgesehen ist,
    - die erste Halbleiterschicht (21) elektrisch leitend mit einem ersten Kontakt (41) verbunden ist,
    - der erste Kontakt (41) auf der Chipvorderseite, insbesondere neben dem aktiven Bereich (20), ausgebildet ist,
    - die zweite Halbleiterschicht (22) elektrisch leitend mit einem zweiten Kontakt (42) verbunden ist,
    - der zweite Kontakt (42) ebenfalls auf der Chipvorderseite, insbesondere neben dem aktiven Bereich (20), ausgebildet ist und
    - eine elektrisch isolierende Trennschicht (6), die die Chiprückseite von dem aktiven Bereich (20) des Halbleiterchips elektrisch isoliert, wobei die elektrisch isolierende Trennschicht (6) eine erste Trennschicht (61) umfasst, die wenigstens eine Atomlagenschicht oder zumindest eine Moleküllagenschicht aufweist und mittels Atomlagenabscheidung oder Moleküllagenabscheidung abgeschieden ist, und zumindest eine zweite Trennschicht (62) umfasst, die eine oder mehrere durch Gasphasenabscheidung oder Sputterverfahren abgeschiedene Lagen aufweist.

2.  Halbleiterchip nach Anspruch 1, wobei die isolierende Trennschicht (6) auf einer Vorderseite (51) des Trägers, auf einer Rückseite (52) des Trägers oder innerhalb des Trägers (5) angeordnet ist.

3.  Halbleiterchip nach einem der vorhergehenden Ansprüche, wobei die Atomlagenschicht und/oder Moleküllagenschicht eine oder mehrere Lagen aufweist.

4.  Halbleiterchip nach einem der vorhergehenden Ansprüche, wobei die erste Trennschicht (61) zumindest eine oder mehrere isolierende Oxid- oder Nitridverbindungen bzw. eine oder mehrere der folgenden Materialien aufweist: $Al_xO_y$, $SiO_2$, $Ta_xO_y$, TaN, TiO, SiN, AlN, TiN, $ZrO_2$, $HfO_2$, $HfSiO_4$, $ZrSiO_4$, HfSiON.

5.  Halbleiterchip nach einem der vorhergehenden Ansprüche, wobei die elektrisch isolierende Trennschicht (6) eine Schichtenfolge aus elektrisch isolierenden Materialien aufweist.

6.  Halbleiterchip nach einem der vorhergehenden Ansprüche, wobei

    - die Trennschicht eine dritte Trennschicht (63) aufweist, wobei die dritte Trennschicht (63) eine oder mehrere durch eine Gasphasenabscheidung oder durch ein Sputterverfahren abgeschiedene Lagen aufweist, und
    - die erste Trennschicht (61) von der zweiten und dritten Trennschicht (62, 63) zumindest teilweise umschlossen ist.

7.  Halbleiterchip nach einem der vorhergehenden Ansprüche, wobei die zweite und/oder die dritte Trennschicht (62, 63) zumindest eine oder mehrere isolierende Oxid- oder Nitridverbindungen bzw. eine oder mehrere der folgenden Materialien aufweisen: $SiN_x$, Si-ON, $SiO_2$, $Al_xO_y$, $Ta_xO_y$, TaN, TiO, SiN, AlN, TiN, $ZrO_2$, $HfO_2$, $HfSiO_4$, $ZrSiO_4$, HfSiON.

8.  Halbleiterchip nach einem der vorhergehenden Ansprüche, wobei der Träger (5) ein elektrisch leitendes Material, halbleitendes Material, ein Moldmaterial, ein keramisches Material und/oder ein hochohmiges Material aufweist.

9.  Halbleiterchip nach einem der vorhergehenden Ansprüche, wobei die erste Halbleiterschicht (21) auf der dem Träger (5) abgewandten Seite des aktiven Bereichs (20) angeordnet und die erste Halbleiterschicht (21) über eine erste Anschlussschicht (31) mit dem ersten Kontakt (41) verbunden ist.

10. Halbleiterchip nach Anspruch 9, wobei der Halbleiterkörper (2) zumindest eine Ausnehmung (25) aufweist, die sich durch die zweite Halbleiterschicht (22) und durch den aktiven Bereich (20) hindurch erstreckt und wobei die erste Anschlussschicht (31) zumindest teilweise in der Ausnehmung (25) angeordnet und mit der ersten Halbleiterschicht (21) verbunden ist.

11. Halbleiterchip nach einem der vorhergehenden Ansprüche,

    - wobei die zweite Halbleiterschicht (22) über eine zweite Anschlussschicht (32) mit dem zweiten Kontakt (42) elektrisch leitend verbunden ist, und
    - wobei die zweite Anschlussschicht (32) auf der dem Träger (5) zugewandten Seite des aktiven Bereichs (20) angeordnet ist.

**12.** Halbleiterchip nach einem der obigen Ansprüche, bei dem

- die elektrisch isolierende Trennschicht (6) vollflächig auf einer Hauptfläche des Trägers (5) ausgebildet ist, und
- die elektrisch isolierende Trennschicht (6) aus der ersten Trennschicht (61), der zweiten Trennschicht (62) und einer dritten Trennschicht (63) gebildet ist, wobei die zweite Trennschicht (62) und die dritte Trennschicht (63) mittels Gasphasenabscheidung gebildet sind,
- die erste Trennschicht (61) zwischen der zweiten Trennschicht (62) und der dritten Trennschicht (63) angeordnet ist, und
- die erste Trennschicht (61) mit der zweiten Trennschicht (62) und der dritten Trennschicht (63) in direktem Kontakt steht.

**13.** Verfahren zum Herstellen eines optoelektronischen Halbleiterchips (1) mit einer Chipvorderseite und einer Chiprückseite, umfassend die Schritte:

- Bereitstellen einer Halbleiterschichtenfolge (2), die einen aktiven Bereich (20) aufweist, der zwischen einer ersten Halbleiterschicht (21) und einer zweiten Halbleiterschicht (22) angeordnet ist;
- Ausbilden eines ersten Kontakts (41) auf der Chipvorderseite, insbesondere neben dem aktiven Bereich (20), und Ausbilden einer elektrisch leitenden Verbindung zwischen der ersten Halbleiterschicht (21) und dem ersten Kontakt (41),
- Ausbilden eines zweiten Kontakts (42) auf der Chipvorderseite, insbesondere neben dem aktiven Bereich (20), und Ausbilden einer elektrisch leitenden Verbindung zwischen der zweiten Halbleiterschicht (22) und dem zweiten Kontakt (42),
- Ausbilden einer elektrisch isolierenden Trennschicht (6) mittels Atomlagenbeschichtung oder Moleküllagenbeschichtung, die die Chiprückseite von dem aktiven Bereich (20) des Halbleiterchips elektrisch isoliert, und
- Bilden eines Verbundes aus Halbleiterschichtenfolge (2) und Träger (5), wobei
- die elektrisch isolierende Trennschicht (6) als eine Kombination aus einer ersten Trennschicht (61) und zumindest einer zweite Trennschicht (62) aufgebracht wird,
- die erste Trennschicht (61) auf Basis einer Atomlagenabscheidung oder Moleküllagenabscheidung ausgeführt wird,
- die zweite Trennschicht (62) auf Basis einer Gasphasenabscheidung oder auf Basis eines Sputterverfahrens ausgeführt wird,

- die Abscheidungen der ersten und zweiten Trennschicht (61, 62) unmittelbar aufeinander erfolgen.

**14.** Verfahren nach Anspruch 13, wobei die elektrisch isolierende Trennschicht (6) mittels zumindest eines der folgenden Atomlagenbeschichtungs- und/oder Moleküllagenbeschichtungs-Verfahren aufgebracht wird:

- atomic layer deposition,
- atomic layer epitaxy,
- atomic layer evaporation,
- atomic layer growth,
- molecular layer deposition,
- molecular layer epitaxy.

**15.** Verfahren nach einem der Ansprüche 13 bis 14, bei dem

- die elektrisch isolierende Trennschicht (6) vollflächig auf einer Hauptfläche des Trägers (5) ausgebildet wird, und
- die elektrisch isolierende Trennschicht (6) aus der ersten Trennschicht (61), der zweiten Trennschicht (62) und einer dritten Trennschicht (63) gebildet wird, wobei die erste Trennschicht (61) zwischen der zweiten Trennschicht (62) und der dritten Trennschicht (63) angeordnet ist und die erste Trennschicht (61) mit der zweiten Trennschicht (62) und der dritten Trennschicht (63) in direktem Kontakt steht,
- die erste Trennschicht (61) mit Atomlagenabscheidung oder Moleküllagenabscheidung gebildet wird, und
- die zweite Trennschicht (62) und dritte Trennschicht (63) mittels Gasphasenabscheidung gebildet werden.

**Claims**

**1.** Optoelectronic semiconductor chip (1), which has a carrier (5) and a semiconductor body (2) having a semiconductor layer sequence, said semiconductor body (2) being arranged on the carrier (5), and said optoelectronic semiconductor chip (1) having a chip front side and a chip rear side, wherein

- the semiconductor layer sequence comprises an active region (20), which is arranged between a first semiconductor layer (21) and a second semiconductor layer (22), and is provided for the generation or reception of electromagnetic radiation,
- the first semiconductor layer (21) is electrically conductively connected to a first contact (41),
- the first contact (41) is formed on the chip front side, in particular next to the active region (20),
- the second semiconductor layer (22) is electrically conductively connected to a second contact (42),
- the second contact (42) is also formed on the chip front side, in particular next to the active region (20), and
- an electrically insulating separation layer (6), which electrically insulates the chip rear side from the active region (20) of the semiconductor chip, the electrically insulating separation layer (6) comprising a first separation layer (61) which has at least one atomic layer or at least one molecular layer and is deposited by means of atomic layer deposition or molecular layer deposition, and at least one second separation layer (62), which has one or more layers deposited by gas phase deposition or sputtering.

2. Semiconductor chip according to claim 1, wherein the insulating separation layer (6) is disposed on a front side (51) of the carrier, on a back side (52) of the carrier or within the carrier (5).

3. Semiconductor chip according to any of the preceding claims, wherein the atomic layer and/or molecular layer comprises one or more layers.

4. Semiconductor chip according to any of the preceding claims, wherein the first separation layer (61) comprises at least one or more insulating oxide or nitride compounds or one or more of the following materials: $Al_xO_y$, $SiO_2$, $Ta_xO_y$, TaN, TiO, SiN, AlN, TiN, $ZrO_2$, $HfO_2$, $HfSiO_4$, $ZrSiO_4$, HfSiON.

5. Semiconductor chip according to any of the preceding claims, wherein the electrically insulating separation layer (6) comprises a layer sequence of electrically insulating materials.

6. Semiconductor chip according to any of the preceding claims, wherein

- the separation layer comprises a third separation layer (63), the third separation layer (63) comprising one or more layers deposited by gas phase deposition or sputtering, and
- the first separation layer (61) is at least partially surrounded by the second and third separation layers (62, 63).

7. Semiconductor chip according to any of the preceding claims, wherein the second and/or the third separation layer (62, 63) comprises at least one or more insulating oxide or nitride compounds or one or more of the following materials: $SiN_x$, Si-ON, $SiO_2$, $Al_xO_y$, $Ta_xO_y$, TaN, TiO, SiN, AlN, TiN, $ZrO_2$, $HfO_2$, $HfSiO_4$, $ZrSiO_4$, HfSiON.

8. Semiconductor chip according to any of the preceding claims, wherein the carrier (5) comprises an electrically conductive material, semiconductive material, a mold material, a ceramic material and/or a high-resistance material.

9. Semiconductor chip according to any of the preceding claims, wherein the first semiconductor layer (21) is arranged on the side of the active region (20) facing away from the carrier (5) and the first semiconductor layer (21) is connected to the first contact (41) via a first connection layer (31).

10. Semiconductor chip according to claim 9, wherein the semiconductor body (2) has at least one recess (25) which extends through the second semiconductor layer (22) and through the active region (20), and wherein the first connection layer (31) is arranged at least partially in the recess (25) and is connected to the first semiconductor layer (21) .

11. Semiconductor chip according to any of the preceding claims,

- wherein the second semiconductor layer (22) is electrically conductively connected to the second contact (42) via a second connection layer (32), and
- wherein the second connection layer (32) is arranged on the side of the active region (20) facing the carrier (5).

12. Semiconductor chip according to any of the above claims, wherein

- the electrically insulating separation layer (6) is formed over the entire surface of a main surface of the carrier (5), and
- the electrically insulating separation layer (6) is formed of the first separation layer (61), the second separation layer (62) and a third separation layer (63), wherein
- the second separation layer (62) and the third separation layer (63) are formed by gas phase deposition,
- the first separation layer (61) is disposed between the second separation layer (62) and the third separation layer (63), and
- the first separation layer (61) is in direct contact with the second separation layer (62) and the third separation layer (63).

13. Method of manufacturing an optoelectronic semiconductor chip (1) having a chip front side and a chip rear side, comprising the steps of:

- providing a semiconductor layer sequence (2) having an active region (20) disposed between a first semiconductor layer (21) and a second semiconductor layer (22),

- forming a first contact (41) on the chip front side, in particular next to the active region (20), and forming an electrically conductive connection between the first semiconductor layer (21) and the first contact (41),

- forming a second contact (42) on the chip front side, in particular next to the active region (20), and forming an electrically conductive connection between the second semiconductor layer (22) and the second contact (42),

- forming an electrically insulating separation layer by means of atomic layer deposition or molecular layer deposition, which electrically insulates the chip rear side from the active region (20) of the semiconductor chip, and

- forming a composite of semiconductor layer sequence (2) and carrier (5), wherein

- the electrically insulating separation layer (6) is applied as a combination of a first separation layer (61) and at least a second separation layer (62),

- the first separation layer (61) is based on atomic layer deposition or molecular layer deposition,

- the second separation layer (62) is based on a gas phase deposition or sputtering,

- the depositions of the first and second separation layers (61, 62) are carried out directly on top of each other.

14. Method according to claim 13, wherein the electrically insulating separation layer (6) is applied by means of at least one of the following atomic layer deposition and/or molecular layer deposition processes:

- atomic layer deposition,
- atomic layer epitaxy,
- atomic layer evaporation,
- atomic layer growth,
- molecular layer deposition,
- molecular layer epitaxy.

15. Method according to any of claims 13 to 14, wherein

- the electrically insulating separation layer (6) is formed over the entire surface of a main surface of the carrier (5), and

- the electrically insulating separation layer (6) is formed of the first separation layer (61), the second separation layer (62) and a third separation layer (63), wherein the first separation layer (61) is disposed between the second separation layer (62) and the third separation layer (63) and the first separation layer (61) is in direct contact with the second separation layer (62) and the third separation layer (63),

- the first separation layer (61) is formed with atomic layer deposition or molecular layer deposition, and

- the second separation layer (62) and third separation layer (63) are formed by gas phase deposition.

**Revendications**

1. Puce semi-conductrice optoélectronique (1) qui présente un support (5) et un corps semi-conducteur (2) disposé sur le support (5) et présentant une séquence de couches semi-conductrices, ainsi qu'une face avant de puce et une face arrière de puce, où

- la séquence de couches semi-conductrices comprend une région active (20) qui est disposée entre une première couche semi-conductrice (21) et une deuxième couche semi-conductrice (22) et qui est prévue pour la génération ou la réception de rayonnement électromagnétique

- la première couche semi-conductrice (21) est connectée de manière électriquement conductrice à un premier contact (41),

- le premier contact (41) est formé sur la face avant de la puce, en particulier à côté de la région active (20),

- la deuxième couche semi-conductrice (22) est connectée de manière électriquement conductrice à un deuxième contact (42),

- le deuxième contact (42) est également formé sur la face avant de la puce, en particulier à côté de la région active (20), et

- une couche de séparation électriquement isolante (6) qui isole électriquement le dos de la puce de la région active (20) de la puce semi-conductrice, la couche de séparation électriquement isolante (6) comprenant une première couche de séparation (61) qui a au moins une couche atomique ou au moins une couche moléculaire et qui est déposée au moyen d'un dépôt de couche atomique ou d'un dépôt de couche moléculaire, et au moins une deuxième couche de séparation (62) qui a une ou plusieurs couches déposées par dépôt en phase gazeuse ou par pulvérisation.

2. Puce semi-conductrice selon la revendication 1, dans laquelle la couche de séparation isolante (6) est disposée sur une face avant (51) du support, sur une face arrière (52) du support ou à l'intérieur du support (5).

3. Puce semi-conductrice selon l'une quelconque des revendications précédentes, dans laquelle la couche atomique et/ou la couche moléculaire comprend une ou plusieurs couches.

4. Puce semi-conductrice selon l'une quelconque des revendications précédentes, dans laquelle la première couche d'isolation (61) comprend au moins un ou plusieurs composés isolants d'oxyde ou de nitrure ou un ou plusieurs des matériaux suivants : $Al_xO_y$, $SiO_2$, $Ta_xO_y$, TaN, TiO, SiN, AlN, TiN, $ZrO_2$, $HfO_2$, $HfSiO_4$, $ZrSiO_4$, HfSiON.

5. Puce semi-conductrice selon l'une quelconque des revendications précédentes, dans laquelle la couche de séparation électriquement isolante (6) comprend une séquence de couches de matériaux électriquement isolants.

6. Puce semi-conductrice selon l'une quelconque des revendications précédentes, dans laquelle

   - la couche de séparation comprend une troisième couche de séparation (63), la troisième couche de séparation (63) comprenant une ou plusieurs couches déposées par un dépôt en phase vapeur ou par pulvérisation, et
   - la première couche de séparation (61) est au moins partiellement entourée par les deuxième et troisième couches de séparation (62, 63).

7. Puce à semi-conducteur selon l'une quelconque des revendications précédentes, dans laquelle la deuxième et/ou la troisième couche de séparation (62, 63) comprend au moins un ou plusieurs composés isolants d'oxyde ou de nitrure ou un ou plusieurs des matériaux suivants: $SiN_x$, Si-ON, $SiO_2$, $Al_xO_y$, $Ta_xO_y$, TaN, TiO, SiN, AlN, TiN, $ZrO_2$, $HfO_2$, $HfSiO_4$, $ZrSiO_4$, HfSiON.

8. Puce semi-conductrice selon l'une quelconque des revendications précédentes, dans laquelle le support (5) comprend un matériau électriquement conducteur, un matériau semi-conducteur, un matériau de moule, un matériau céramique et/ou un matériau à haute résistance.

9. Puce semi-conductrice selon l'une quelconque des revendications précédentes, dans laquelle la première couche semi-conductrice (21) est disposée sur le côté de la région active (20) opposé au support (5) et la première couche semi-conductrice (21) est reliée au premier contact (41) par une première couche de connexion (31).

10. Puce semi-conductrice selon la revendication 9, dans laquelle le corps semi-conducteur (2) présente au moins un évidement (25) qui s'étend à travers la deuxième couche semi-conducteur (22) et à travers la région active (20), et dans laquelle la première couche de connexion (31) est disposée au moins partiellement dans l'évidement (25) et est reliée à la première couche semi-conductrice (21).

11. Puce semi-conductrice selon l'une quelconque des revendications précédentes,

   - dans lequel la deuxième couche semi-conductrice (22) est connectée de manière électriquement conductrice au deuxième contact (42) via une deuxième couche de connexion (32), et
   - dans lequel la seconde couche de connexion (32) est disposée sur le côté de la région active (20) faisant face au support (5) .

12. Puce semi-conductrice selon l'une des revendications précédentes, dans laquelle

   - la couche de séparation électriquement isolante (6) est formée sur la totalité de la surface d'une surface principale du substrat (5), et
   - la couche de séparation électriquement isolante (6) est formée de la première couche de séparation (61), de la deuxième couche de séparation (62) et d'une troisième couche de séparation (63), où
   - la deuxième couche de séparation (62) et la troisième couche de séparation (63) sont formées par dépôt en phase gazeuse,
   - la première couche de séparation (61) est disposée entre la deuxième couche de séparation (62) et la troisième couche de séparation (63), et
   - la première couche de séparation (61) est en contact direct avec la deuxième couche de séparation (62) et la troisième couche de séparation (63).

13. Procédé de fabrication d'une puce semi-conductrice optoélectronique (1) ayant une face avant de puce et une face arrière de puce, comprenant les étapes consistant à:

   - fournir une séquence de couches semi-conductrices (2) ayant une région active (20) disposée entre une première couche semi-conductrice (21) et une seconde couche semi-conductrice (22),
   - former un premier contact (41) sur la face avant de la puce, en particulier à côté de la région active (20), et former une connexion électriquement conductrice entre la première couche semi-conductrice (21) et le premier contact (41),
   - former un deuxième contact (42) sur la face avant de la puce, en particulier à côté de la région active (20), et former une connexion électriquement conductrice entre la deuxième couche semi-conductrice (22) et le deuxième contact (42),
   - former une couche de séparation électriquement isolante au moyen d'un revêtement de couche atomique ou d'un revêtement de couche moléculaire, qui isole électriquement la face arrière de la puce de la région active (20) de la puce semi-conductrice,
et

- former un composite de séquence de couches semi-conductrices (2) et de support (5), dans lequel

- la couche de séparation électriquement isolante (6) est appliquée sous la forme d'une combinaison d'une première couche de séparation (61) et d'au moins une deuxième couche de séparation (62),

- la première couche de séparation (61) est basée sur un dépôt de couche atomique ou un dépôt de couche moléculaire,

- la deuxième couche de séparation (62) est basée sur un dépôt en phase gazeuse ou sur pulvérisation,

- les dépôts des première et deuxième couches de séparation (61, 62) sont effectués directement l'un sur l'autre.

14. Procédé selon la revendication 13, dans lequel la couche de séparation électriquement isolante (6) est appliquée au moyen d'au moins un des procédés suivants de dépôt de couche atomique et/ou de dépôt de couche moléculaire :

- dépôt de couches atomiques,
- épitaxie en couche atomique,
- évaporation de la couche atomique,
- la croissance de la couche atomique,
- dépôt de couches moléculaires,
- épitaxie en couche moléculaire.

15. Procédé selon l'une quelconque des revendications 13 à 14, dans lequel

- la couche de séparation électriquement isolante (6) est formée sur toute la surface d'une surface principale du substrat (5), et
- la couche de séparation électriquement isolante (6) est formée de la première couche de séparation (61), de la deuxième couche de séparation (62) et d'une troisième couche de séparation (63), dans laquelle la première couche de séparation (61) est disposée entre la deuxième couche de séparation (62) et la troisième couche de séparation (63) et la première couche de séparation (61) est en contact direct avec la deuxième couche de séparation (62) et la troisième couche de séparation (63),
- la première couche de séparation (61) est formée par dépôt de couche atomique ou par dépôt de couche moléculaire, et
- la deuxième couche de séparation (62) et la troisième couche de séparation (63) sont formées par dépôt en phase gazeuse.

## FIG 1

## FIG 2

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011115659 A1
- US 20130285067 A1
- DE 102010048159 A1
- DE 102010013494 A1
- DE 102007022947 A1
- US 20100140636 A1
- WO 2014090605 A1
- DE 102015116495